# EUROPEAN PATENT APPLICATION

(11) **EP 1 624 507 A1**
(43) Date of publication of application: **08.02.2006**
(21) Application number: 05014701.6
(22) Date of filing: 06.07.2005
(51) Int. Cl.: H01M 2/22, H01M 10/04, H01M 2/20, H05K 7/02, H05K 7/10, H05K 1/11, H05K 1/18

(54) **Secondary cell device having a connection interface**

(30) Priority: 28.07.2004 CN 200410071085
(71) Applicant: Antig Technology Co., Ltd., 114 Taipei (TW)
(72) Inventor: Shu, His-Ming, Hsin Chuang City Taipei Hsien (TW); Chen, Cheng-Hsin, BeiTou Taipei (TW); Shen, Ko-Chen, NeiHu Taipei (TW)
(74) Representative: Viering, Jentschura & Partner

(57) **Abstract**

A secondary cell device having a connection interface, including: a PCB, plural secondary cell units, and an electrical connection interface. The secondary cell units are made by a PCB fabrication processes and provided on the PCB. The secondary cell units are directly made of a part of the PCB material. The electrical connection interface is provided on the PCB and forms an electrical connection with the secondary cell units electrical connection, and at least serves as output terminals for power generated by the secondary cell units.

## Description

### FIELD OF THE INVENTION

This invention relates to a secondary cell, particularly relating to one made by using PCB (Printed Circuit Board) fabrication processes and equipped with an electrical connection interface.

### BACKGROUND OF THE INVENTION

The conventional secondary cells, such as Lithium rechargeable cells and Ni-H rechargeable cells, all adopt metal packaging casings, into which elements for constructing the rechargeable cell, including the positive pole, negative pole, insulation film and electrolyte substance, are packed. The conventional secondary cells are mostly individually packed, such that more than one type of conventional secondary cells are to be connected in series or parallel, a cell housing is needed or wires are adopted to weld them together, which are then subsequently packed together by means of a packaging material. When more than one conventional secondary cell is to be connected in series or parallel, regardless of whether the cell housing or wire welding means is adopted, the conventional secondary cells that are connected together doubtlessly result in a relatively large volume.

In view of the difficulties involved in incorporating more than one conventional secondary cell, a secondary cell device having connection interface is developed so as to allow easy incorporation of plural secondary cell devices in use.

### SUMMARY OF THE INVENTION

It is a first object of this invention to provide a secondary cell device made by PCB fabrication processes, where more and more such secondary cell devices can be easily connected to each other.

It is a second object of this invention to provide a secondary cell device made by PCB fabrication processes, where such secondary cell devices can easily meet the needs of modularization.

To achieve the objects of this invention, this invention provides a secondary cell device having a connection interface, including: a PCB; plural secondary cell units provided on the PCB, wherein the secondary cell units are made of part of the PCB material; an electrical connection interface provided on the PCB and forming electrical connection with the secondary cell units, and at least serving as an output terminal for power generated by the secondary cell units.

### BRIEF DESCRIPTION OF THE DRAWINGS

These and other modifications and advantages will become even more apparent from the following detained description of a preferred embodiment of the invention and from the drawings in which:
Fig. 1 illustrates a structural schematic drawing of the secondary cell device having a connection interface of this invention;
Fig. 2 illustrates a preferred embodiment of this invention embodying the structure illustrated in Fig. 1;
Fig. 3 illustrates a structural schematic drawing of an expansion board of this invention; and
Fig. 4 illustrates an arrangement where this invention is implemented in an electronic device.

### DETAILED DESCRIPTION OF THE INVENTION

This invention discloses a secondary cell device having connection interface 10, including: plural secondary cell units 101; and particularly an electrical connection interface 103, where the electrical connection interface 103 of the plural secondary cell devices 10 are connected to each other. This invention is able to integrate power generated by plural secondary cell devices 10 in a flexible manner so as to construct a power supply. Furthermore, the electrical connection interface 103 of the secondary cell devices 10 is also an output terminal or input terminal of control signals, which serves as a communication channel in the power management of the secondary cell devices 10.

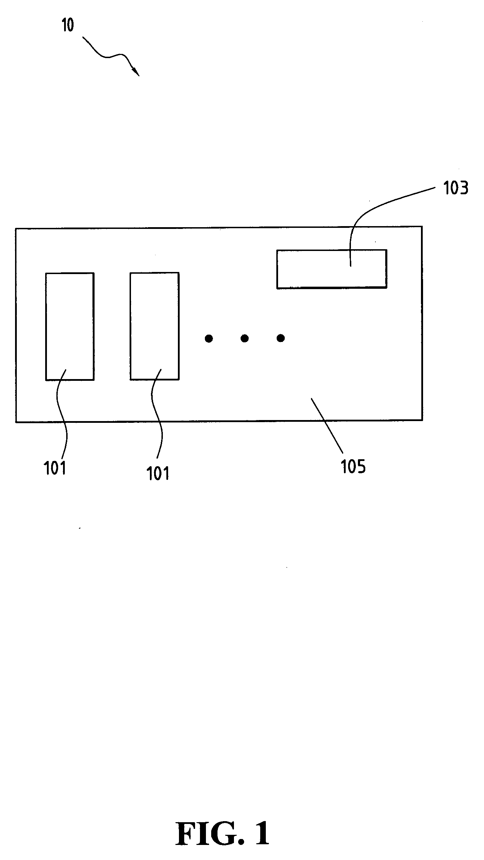

Fig. 1 illustrates a structural schematic drawing of the secondary cell device having connection interface of this invention. The secondary cell device 10 of this invention includes: plural secondary cell units 101, an electrical connection interface 103 and a PCB (Printed Circuit Board) 105, described in detail as follows. The plural secondary cell units 101 are provided on the PCB 105 and directly made of a part of the material making the PCB 105 by means of PCB fabrication processes. The positive poles and negative poles of the secondary cell units 101 may be connected to each other in series or in parallel. The secondary cell units 101 of the invention provided on the PCB 105 may be arranged in a single row or in a matrix arrangement. The secondary cell units 101 may implement Li rechargeable cells, Ni-H rechargeable cells, and Li high-polymer rechargeable cells.

The electrical connection interface 103 is provided on the PCB 105 and forms the electrical connection of the secondary cell units 101. One function of the electrical connection interface 103 is to serve as the output terminals of the power generated by the secondary cell units 101.

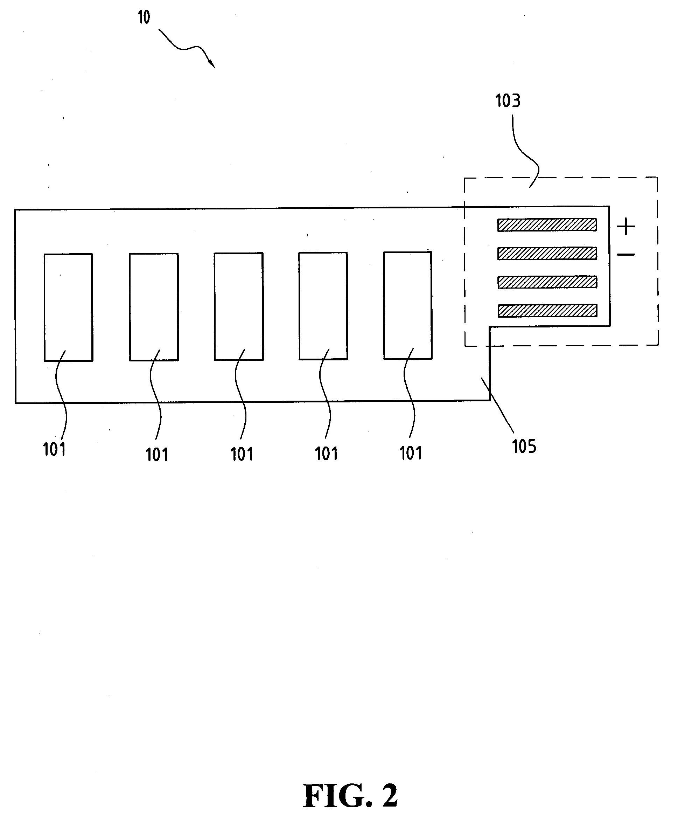

Fig. 2 illustrates a preferred embodiment of this invention embodying the structure illustrated in Fig. 1. In Fig. 2, the electrical connection interface 103 is a gold finger provided to a lateral side of the PCB 105. The main function of the gold finger 103 is to serve as summative output terminals of the positive poles and negative poles of the secondary cell units 101 that are connected to each other in series or parallel, depicted by the "+" and "-" symbols in Fig. 2. The remaining terminals of the gold finger 103 mainly serve as output terminals and input terminals of control signals used by the secondary cell units 101. For example, the control signals may include temperature detection signals, abnormality alarming signals, and data signals.

Of course, the electrical connection interface 103 may implement a gold finger, a female type connector, a male type connector, a miniature electrical connector, or any other suitable forms of electrical connectors.

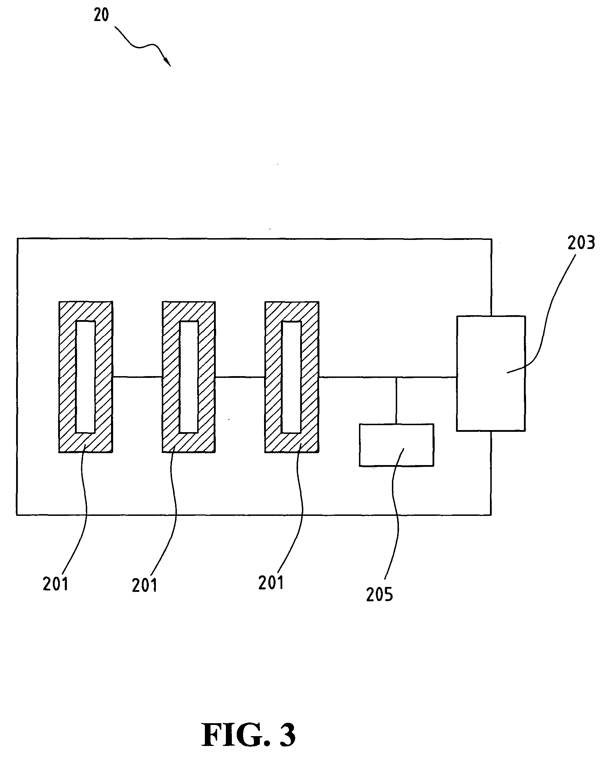

Fig. 3 illustrates a structural schematic drawing of an expansion board of this invention. The expansion board 20 mainly serves to assemble plural sheets of secondary cell devices 10 together so as to integrate power generated by plural sheets of secondary cell devices 10 so as to improve the overall power wattage. In Fig. 3, the expansion board 20 includes at least one electrical connector 201, a connection interface 203, and a circuit 205, described in detail as follows:

Such electrical connectors 201 serve to connect to the respective electrical connection interface 103 of the secondary cell devices 10. The electrical connectors 201 may implement an electrical connector adapted to the configuration of the electrical connection interface 103. For example, for a gold finger type electrical connection interface 103, the electrical connector 201 is a slot connecter. Through such electrical connectors 201 that are connected to the respective electrical connection interfaces 103, the power and control signals of the secondary cell device 10 can all be transmitted to the expansion board 20.

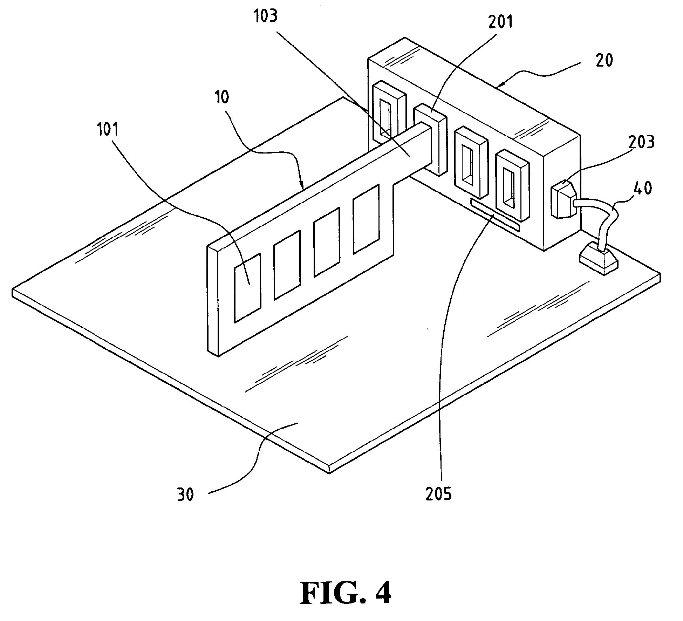

The connection interface 203 serves as a communication channel for the expansion board 20. With reference to Fig. 4, the connection interface 203 is connected to an electronic device 30 by means of a cable 40, such that power generated by the secondary cell device 10 integrated by the expansion board 20 is able to be transmitted by the electronic device 30.

Furthermore, the circuit 205 of the expansion board 20 may include a serial/parallel circuit, through which the power generated by the secondary cell devices 10 is integrated and then transmitted to the electronic device 30 through transmission of the connection interface 203. The circuit 205 of the expansion board 20 may be a power management circuit for managing the power wattage of the secondary cell devices 10. The circuit 205 of the expansion board 20 may also be a charging circuit for charging all secondary cell units of the secondary cell devices 10.

The electrical connection interface 103 of the secondary cell device 10 of this invention may also adopt a pluggable electrical connection interface to allow easy plug-in or removal assembly operation to the expansion board 20.

The secondary cell device 10 of this invention is able to achieve the following effects due to the provision of the electrical connection interface 103:
1. The electrical connection interface 103 provided by this invention and the connection by means of the expansion board 20 allows power to be supplied by more than one secondary cell devices 10 at the same time, thereby forming a modular power supply;
2. The provision of the circuit 205 to the expansion board 20 in this invention allows connection of plural secondary cell devices 10 in series or parallel, so as to output the desired voltage wattage; and
3. This invention allows direct provision of the expansion board 20 on the electronic device 30, such as an expansion board 20 built in a computer main board to allow direction insertion of plural secondary cell devices 10, so as to serve as a built-in power supply of the electronic device 30.

This invention is related to a novel creation that makes a breakthrough in the art. Aforementioned explanations, however, are directed to the description of preferred embodiments according to this invention. Since this invention is not limited to the specific details described in connection with the preferred embodiments, changes and implementations to certain features of the preferred embodiments without altering the overall basic function of the invention are contemplated within the scope of the appended claims.

## Claims

1. A secondary cell device having connection interface, comprising:
a PCB (Printed Circuit Board);
plural secondary cell units provided on the PCB, wherein the secondary cell units are made of a part of the PCB material;
an electrical connection interface provided on the PCB, forming an electrical connection with the secondary cell units electrical connection, and at least serving as an output terminal for power generated by the secondary cell units.

2. The secondary cell device of claim 1, wherein the electrical connection interface is a gold finger provided on the PCB.

3. The secondary cell device of claim 1, wherein the electrical connection interface is a female type connector provided on the PCB.

4. The secondary cell device of claim 1, wherein the electrical connection interface is a male type connector provided on the PCB.

5. The secondary cell device of claim 1, wherein the electrical connection interface is a miniature electrical connector provided on the PCB.

6. The secondary cell device of claim 1, wherein the electrical connection interface further serve as an output terminal for control signals of the secondary cell units.

7. The secondary cell device of claim 1, wherein the electrical connection interface further serve as an input terminal for control signals of the secondary cell units.

8. The secondary cell device of claim 1, wherein the secondary cell units are each selected from a Li rechargeable cells, Ni-H rechargeable cells, and Li high-polymer rechargeable cells.

9. The secondary cell device of claim 1, wherein the electrical connection interface of the secondary cell device is a pluggable electrical connection interface.

10. The secondary cell device of claim 1, wherein the secondary cell devices are connected to the electrical connection interface by means of an expansion board,
wherein the expansion board is subsequently connected to the electrical connection interface of another secondary cell device.

11. The secondary cell device of claim 10, wherein the expansion board includes at least one electrical connector mating with the electrical connection interface and serving as electricity transmission path for the power and control signals of the secondary cell devices connected to the expansion board.

12. The secondary cell device of claim 10, wherein the expansion board further includes a connection interface serving as electrical connection with an electronic device.

13. The secondary cell device of claim 10, wherein the expansion board further includes a circuit.

14. The secondary cell device of claim 13, wherein the circuit is a serial/parallel circuit for connecting the power generated by the secondary cell devices connected to the expansion board in series/parallel.

15. The secondary cell device of claim 13, wherein the circuit is a power management circuit.

16. The secondary cell device of claim 13, wherein the circuit is a charging circuits.
